# EUROPÄISCHE PATENTSCHRIFT

(11) **EP 1 040 558 B1**
(45) Veröffentlichungstag und Bekanntmachung des Hinweises auf die Patenterteilung: **02.05.2003**
(21) Anmeldenummer: 98964382.0
(22) Anmeldetag: 04.12.1998
(51) Int. Cl.: H02M 3/156

(54) **VERFAHREN ZUM BEEINFLUSSEN DER ELEKTRISCHEN LEISTUNG EINER LAST MIT EINEM IMPULSBREITENMODULIERTEN SIGNAL**
METHOD FOR INFLUENCING THE ELECTRICAL POWER OF A LOAD WITH A PULSE WIDTH MODULATED SIGNAL
PROCEDE PERMETTANT D'AGIR SUR LA PUISSANCE ELECTRIQUE D'UNE CHARGE AVEC UN SIGNAL MODULE EN DUREE D'IMPULSION

(30) Priorität: 18.12.1997 DE 19756461
(43) Veröffentlichungstag der Anmeldung: 04.10.2000
(73) Patentinhaber: ROBERT BOSCH GMBH, 70442 Stuttgart (DE)
(72) Erfinder: BORHO, Lothar, D-77731 Willstätt (DE); PREIS, Karl-Heinrich, D-77830 Bühlertal (DE)
(86) Internationale Anmeldenummer: DE9803566
(87) Internationale Veröffentlichungsnummer: WO99033161

(56) Entgegenhaltungen:
- EP-A- 0 735 660
- US-A- 4 471 283
- US-A- 4 926 104

## Beschreibung

### Stand der Technik

Die Erfindung geht aus von einer Vorrichtung zum Beeinflussen der elektrischen Leistung einer Last mit einem impulsbreitenmodulierten Signal nach der Gattung des unabhängigen Anspruchs. Aus einem Fachbuch von L. Retzbach, "Drehzahlregler", Neckar-Verlag, Villingen-Schwenningen, 2. Auflage 1982, sind Verfahren zum Beeinflussen der elektrischen Leistung von Gleichstrom-Elektromotoren mit einem impulsbreitenmodulierten Signal bekannt. Auf Seiten 21 - 24 ist ein Drehzahlreglerprinzip beschrieben, das einen Impulsbreitenmodulator enthält. Ein als Modulator bezeichneter Komparator vergleicht eine Gleichspannung, die ein Maß für den Sollwert der elektrischen Leistung des Gleichstrom-Elektromotors ist, mit einer Wechselspannung, die ein Sägezahnspannungsgenerator bereitstellt. Diejenige Zeit, während der die Gleichspannung das Wechselspannungssignal übersteigt, legt beispielsweise die Einschaltzeit fest. Die Grundperiodendauer des erzeugten impulsbreitenmodulierten Signals ist von der Grundfrequenz des Sägezahnspannungsgenerators festgelegt. Bei der Erzeugung des impulsbreitenmodulierten Signals können zwei, in der angegebenen Literaturstelle nicht näher beschriebene Grenzfälle auftreten. Die Grenzfälle liegen vor, wenn die Gleichspannung ständig unterhalb oder oberhalb der vom Generator bereitgestellten sägezahnförmigen Spannung liegt. In einem Betriebsfall treten keine Einschaltzeiten mehr auf. Der Elektromotor wird dann nicht mehr bestromt. Im anderen Betriebsfall geht das impulsbreitenmodulierte Signal in ein Dauereinschaltsignal über, so daß der Elektromotor ständig voll bestromt wird. Ein Schutz gegen Überlastung des Elektromotors und der Endstufenschaltung gegen das Auftreten eines Überstroms ist durch die auf Seiten 83 und 84 beschriebene Motorstromerfassung vorgesehen. Eine Ausführung sieht die Auswertung des an der Schaltstrecke des Endstufenschalters auftretenden Spannungsabfalls während der Einschaltzeit vor.

Aus der EP 0 735 660 A1 ist eine Vorrichtung bekannt, welche einen bürstenlosen Gleichstrommotor mit einem impulsbreitenmodulierten Signal ansteuert und zwar während der Startphase des Motors, um den Leistungsverlust möglichst gering zu halten.

Der Erfindung liegt die Aufgabe zugrunde, eine Vorrichtung zum Beeinflussen der elektrischen Leistung einer Last mit einem impulsbreitenmodulierten Signal, das die Vorgabe eines Dauereinschaltsignals einschließt, anzugeben, welche die Erfassung einer Betriebsgröße der Last ermöglicht.

Die Aufgabe wird durch die im unabhängigen Anspruch angegebenen Merkmale gelöst.

### Vorteile der Erfindung

Die erfindungsgemäße Vorrichtung weist den Vorteil auf, daß bei der Vorgabe eines Dauereinschaltsignals, das als Grenzfall bei einem impulsbreitenmodulierten Signal auftreten kann, weiterhin eine Betriebsgröße der Last erfaßt werden kann, die nur durch eine zumindest kurzzeitige Änderung der der Last zugeführten elektrischen Leistung erfaßbar ist. Eine solche Betriebsgröße ist beispielsweise eine Stromänderung, die bei einer Veränderung der der Last zugeführten elektrischen Leistung auftritt.

Erfindungsgemäß ist hierzu vorgesehen, daß die Stromermittlung die an einem vom Strom durchflossenen induktiven Element auftretende induzierte Spannung auswertet und daß zur Leistungsänderung die Erzeugung eines Unterbrechungssignals vorgesehen ist, welches das Dauereinschaltsignal wenigstens für eine Ausschaltzeit des impulsbreitenmodulierten Signals unterbricht.

Die erfindungsgemäße Vorrichtung weist den Vorteil auf, daß der Last im Rahmen einer Beeinflussung der elektrischen Leistung mit einem impulsbreitenmodulierten Signal einerseits wenigstens näherungsweise die volle Leistung zur Verfügung gestellt werden kann und andererseits eine zumindest kurzzeitige Änderung der elektrischen Leistung auftritt, wobei die kurzzeitige Änderung beispielsweise zum Erfassen einer Betriebsgröße der Last ausgenutzt werden kann.

Vorteilhafte Weiterbildungen und Ausgestaltungen der erfindungsgemäßen Vorrichtung ergeben sich aus abhängigen Ansprüchen.

Eine besonders vorteilhafte Ausgestaltung der erfindungsgemäßen Vorrichtung sieht vor, daß eine programmgesteuerte signalverarbeitende Anordnung, die vorzugsweise das impulsbreitenmodulierte Signal erzeugt, das Unterbrechungssignal nach einem Programmdurchlauf erzeugt. Mit dieser Maßnahme wird eine einfache Realisierung des Programmablaufs erreicht.

Insbesondere ergibt sich der Vorteil, daß das in der signalverarbeitenden Anordnung ablaufende Programm mit der Erzeugung des Unterbrechungssignals genau zu demjenigen Zeitpunkt eine Beeinflussung der elektrischen Leistung der Last bewirkt, zu dem das Programm der signalverarbeitenden Anordnung die Auswirkungen der Leistungsänderung erwartet. Ein unnötiges Anhalten des übrigen Programmablaufs wird dadurch vermieden.

Eine andere vorteilhafte Ausgestaltung sieht vor, daß das Unterbrechungssignal aufgrund eines externen Anforderungssignals auftritt. Mit dieser Maßnahme ist eine gezielte Beendigung des Dauereinschaltsignals möglich, wobei das externe Anforderungssignal vorzugsweise von der Anordnung abgegeben wird, welche die Betriebsgröße der Last ermittelt.

Weitere vorteilhafte Ausgestaltungen sehen vor, daß die Zeitdauer der Taktphase, die sich an das Dauereinschaltsignal anschließt, ein ganzzahliges Vielfaches der Grundperiodendauer des impulsbreitenmodulierten Signals beträgt.

Das erfindungsgemäße Verfahren ermöglicht die Erfassung einer Meßgröße im Bereich der Ausschaltzeit, die während der Taktphase auftritt. Eine solche Meßgröße ist beispielsweise eine Änderung des durch die Last fließenden Stroms. Die Stromänderung führt an einer im Stromkreis liegenden induktiven Komponente, beispielsweise an einer induktivitätsbehafteten Leiterbahn einer gedruckten Schaltung, zu einem induktiven Spannungsabfall, der proportional zur Stromänderung ist. Mit einem Integrator kann von der Stromänderung auf den absoluten Strom geschlossen werden.

Weitere vorteilhafte Ausgestaltungen und Weiterbildungen der erfindungsgemäßen Vorrichtung ergeben sich aus weiteren abhängigen Ansprüchen und aus der folgenden Beschreibung.

### Zeichnung

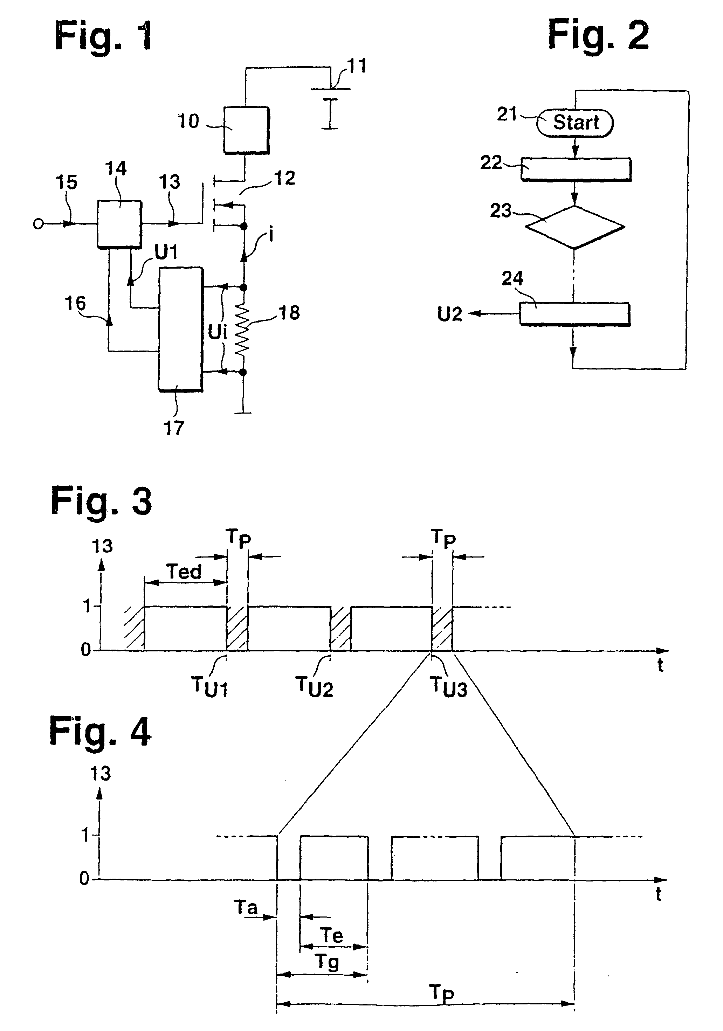

Figur 1 zeigt ein Blockschaltbild einer Schaltung, in der das erfindungsgemäße Verfahren abläuft, Figur 2 zeigt einen Ausschnitt eines Flußdiagramms, Figur 3 zeigt einen Signalverlauf bei der Vorgabe eines Dauereinschaltsignals und Figur 4 zeigt einen zeitgedehnten Ausschnitt des in Figur 3 gezeigten Signalverlaufs.

Figur 1 zeigt eine Last 10, die von einer Energiequelle 11 gespeist wird. Die Last 10 ist über einen Schalter 12 mit der Energiequelle 11 verbindbar. Der Schalter 12 wird von einem impulsbreitenmodulierten Signal 13 angesteuert, das eine signalverarbeitende Anordnung 14 in Abhängigkeit von einem Leistungsvorgabesignal 15 und einem Leistungsbegrenzungssignal 16 erzeugt. Das Leistungsbegrenzungssignal 16 wird von einer Stromermittlung 17 bereitgestellt, die den durch den Schalter 12 und durch die Last 10 fließenden Strom i ermittelt. Die Stromermittlung wertet eine induzierten Spannung Ui aus, die an einem induktiven Element 18 auftritt, das vom Strom i durchflossen ist. Die Stromermittlung 17 gibt weiterhin ein erstes Unterbrechungssignal U1 an die signalverarbeitende Anordnung 14 ab.

Mit dem in Figur 1 gezeigten Blockschaltbild kann folgendes Verfahren realisiert werden.

Die signalverarbeitende Anordnung 14, die vorzugsweise programmgesteuert ist, erzeugt in Abhängigkeit vom Leistungsvorgabesignal 15 das impulsbreitenmodulierte Signal 13, das den Schalter 12 in zeitlicher Folge entweder vollständig einschaltet oder ausschaltet. Das impulsbreitenmodulierte Signal 13 stellt über den Schalter 12 der Last 10 eine mittlere Spannung zur Verfügung, die von der Energiequelle 11 aufgebracht wird. Eine Änderung der mittleren, der Last 10 zur Verfügung gestellten Spannung wirkt sich auf den mittleren, durch die Last 10 fließenden Strom i aus. Das impulsbreitenmodulierte Signal 13 ermöglicht deshalb die Beeinflussung der Last 10 zugeführten elektrischen Leistung. Handelt es sich bei der Last 10 beispielsweise um einen Elektromotor, so kann mittels des impulsbreitenmodulierten Signals 13 beispielsweise die Drehzahl auf einem vorgegebenen Wert konstant gehalten werden. Die Erfassung des Motorstroms ermöglicht alternativ das Konstanthalten des vom Elektromotor bereitgestellten Drehmoments.

Die größtmögliche Leistung der Last 10 tritt auf, wenn der Schalter 12 vom impulsbreitenmodulierten Signal 13 ständig eingeschaltet wird. Ein solches Dauereinschaltsignal ist, ebenso wie ein vollständiges Abschaltsignal, ein Spezialfall des impulsbreitenmodulierten Signals 13. Ein auf unbestimmte Zeit festgelegtes volles Bestromen der Last 10 ist nicht in allen Fällen möglich. Ein derartiger Fall tritt auf, wenn eine Betriebsgröße der Last 10 zu erfassen ist, bei der die Leistung zumindest kurzzeitig eine Änderung aufweisen muß. Die Stromermittlung 17 wertet einen induktiven Spannungsabfall Ui aus, der am induktiven Element 18 auftritt. Ausgenutzt werden kann der induktive Belag einer Leitung, die den Strom i führt. Eine auf einer Leiterbahn gedruckte Leitung weist beispielsweise eine ausreichende Induktivität auf. Die induzierte Spannung Ui ist proportional zur Induktivität und zur Ableitung des Stroms i nach der Zeit. Ein in der Stromermittlung enthaltener Integrator, der die Stromänderungen aufsummiert, stellt ein Signal bereit, das proportional zum Strom i ist. Durch Vergleich mit einem vorgegebenen Schwellenwert kann das Leistungsbegrenzungssignal 16 an die signalverarbeitende Anordnung 14 abgegeben werden. Das Leistungsbegrenzungssignal 16 signalisiert das Vorliegen eines Überstroms und veranlaßt die signalverarbeitende Anordnung 14 zum Verändern des impulsbreitenmodulierten Signals 13 bis hin zum völligen Abschalten der Last 10.

Die zumindest kurzzeitig vorgesehene Leistungsänderung bei einem vorliegenden Dauereinschaltsignal des impulsbreitenmodulierten Signals 13 wird erfindungsgemäß dadurch möglich, daß das Dauereinschaltsignal mit einem Unterbrechungssignal beendet wird und daß dem Dauereinschaltsignal eine Taktphase mit wenigstens einer eine Ausschaltzeit enthaltende Grundperiodendauer folgt. Das Unterbrechungssignal wird beispielsweise von der Stromermittlung 17 als externes Unterbrechungssignal U1 bereitgestellt.

Figur 2 zeigt im rahmen eines Flußdiagramms eine andere Möglichkeit zur Bereitstellung des Unterbrechungssignals. Das Unterbrechungssignal tritt bei einem Programmdurchlauf auf, der beispielsweise innerhalb der signalverarbeitenden Anordnung 14 ablaufen kann. Das Programm beginnt mit dem Start 21 und führt über Anweisungen 22 und Abfragen 23 zur am Ende des Programms liegenden Anweisung 24, die ein programmerzeugtes Unterbrechungssignal U2 erzeugt. Nach der Anweisung 24 findet ein Rücksprung zum Start 21 statt. Im Rahmen des in Figur 2 gezeigten Flußdiagramms kann auch das impulsbreitenmodulierte Signal 13 selbst erzeugt werden. Der wesentliche Vorteil der Realisierung des programmgesteuerten Unterbrechungssignals U2 liegt darin, daß die Bereitstellung des programmgesteuerten Unterbrechungssignals U2 innerhalb des normalen Programmablaufs erfolgt. Ein Eingriff in das Programm, der bei dem externen Unterbrechungssignal U1 erforderlich ist, kann entfallen.

Die Auswirkung des erfindungsgemäßen Verfahrens auf das impulsbreitenmodulierte Signal wird anhand der in den Figuren 3 und 4 gezeigten Signalverläufe in Abhängigkeit von der Zeit verdeutlicht:
Figur 3 zeigt das impulsbreitenmodulierte Signal 13 in Abhängigkeit von der Zeit, wobei die Ordinatenbeschriftung "1" bedeutet, daß der Schalter 12 eingeschaltet ist, während die Beschriftung "0" bedeutet, daß der Schalter 12 ausgeschaltet ist. Dargestellt ist der Betriebsfall, bei dem das impulsbreitenmodulierte Signal 13 als Dauereinschaltsignal auftritt. Erfindungsgemäß ist vorgesehen, daß das Dauereinschaltsignal beendet wird, wenn ein Unterbrechungssignal U1, U2 auftritt. Dies ist der Fall zu den Zeitpunkten Tu1, Tu2, Tu3. Das unterbrochene Dauereinschaltsignal weist eine Einschaltdauer auf, die in Figur 3 mit Ted bezeichnet ist. Die Einschaltdauer Ted wird gefolgt jeweils von Taktphasen Tp.
Figur 4 zeigt eine Taktphase Tp mit einem gegenüber Figur 3 vergrößerten Zeitmaßstab. Innerhalb der Taktphase Tp tritt zumindest eine Ausschaltzeit Ta des impulsbreitenmodulierten Signals 13 auf. Nach der einen Ausschaltdauer Ta kann das impulsbreitenmodulierte Signal 13 wieder in das Dauersignal übergehen. Von der in Figur 4 eingetragenen Grundperiodendauer Tg des impulsbreitenmodulierten Signals 13, die sich zusammensetzt aus der Ausschaltzeit Ta und der Einschaltzeit Te würde dann nur die Ausschaltzeit Ta sichtbar, da dann die Einschaltzeit Te bereits dem Auftreten des Dauereinschaltsignals zuzurechnen wäre. Vorzugsweise sind in der Taktphase Tp mehrere Grundperiodendauern Tg enthalten. Mit dieser Maßnahme wird der Vorteil erzielt, daß eine ausreichende Änderung der der Last zugestandenen Leistung erzielbar ist, ohne daß auf eine vergleichsweise hochfrequente Taktung verzichtet werden muß. Die Ausschaltzeit Ta kann deshalb auf einen minimalen konstanten Wert festgehalten werden. Eine aus programmtechnischer Sicht besonders einfache Realisierung ergibt sich, wenn die Taktphase Tp ein ganzzahliges Vielfaches der Grundperiodendauer Tg beträgt.

## Patentansprüche

1. Vorrichtung zum Beeinflussen der elektrischen Leistung einer Last (10), mit einer signalverarbeitenden Anordnung (14), die einen in Reihe mit der Last (10) geschalteten Schalter (12) mit einem impulsbreitenmodulierten Signal (13) ansteuert, wobei die signalverarbeitende Anordnung (14) das impulsbreitenmodulierte Signal (13) festlegt bis hin zu einem Dauereinschaltsignal, bei dem die Last (10) vollständig eingeschaltet ist, und mit einer Stromermittlung (17), **dadurch gekennzeichnet, daß** die Stromermittlung (17) die an einem vom Strom (i) durchflossenen induktiven Element (18) auftretende induzierte Spannung (Ui) auswertet und daß zur Leistungsänderung die Erzeugung eines Unterbrechungssignals (U1, U2) vorgesehen ist, welches das Dauereinschaltsignal wenigstens für eine Ausschaltzeit (Ta) des impulsbreitenmodulierten Signals (13) unterbricht.

2. Vorrichtung nach Anspruch 1, **dadurch gekennzeichnet, daß** das Unterbrechungssignal (U2) ein Programm bereitstellt, das in der signalverarbeitenden Anordnung (14) abläuft.

3. Vorrichtung nach Anspruch 2, **dadurch gekennzeichnet, daß** die Erzeugung des Unterbrechungssignals (U2) nach jedem Programmdurchlauf vorgesehen ist.

4. Vorrichtung nach Anspruch 1, **dadurch gekennzeichnet, daß** das Unterbrechungssignal (U1) ein externes Signal ist.

5. Vorrichtung nach Anspruch 1, **dadurch gekennzeichnet, daß** das Unterbrechungssignal (U1, U2) das Dauereinschaltsignal für die Dauer einer Taktphase (Tp) unterbricht, die einem ganzzahligen Vielfachen der Grundperiodendauer (Tg) des impulsbreitenmodulierten Signals (13) entspricht.

6. Vorrichtung nach einem der vorhergehenden Ansprüche, **dadurch gekennzeichnet, daß** die Auswertung der induzierten Spannung (Ui) im Bereich der Ausschaltzeit (Ta) des impulsbreitenmodulierten Signals (13) vorgesehen ist.

7. Vorrichtung nach Anspruch 1, **dadurch gekennzeichnet, daß** das induktive Element (18) eine auf einer gedruckten Schaltung angeordnete Leiterbahn ist.

## Claims

1. Device for influencing the electrical power of a load (10), having a signal-processing arrangement (14), which drives a switch (12) connected in series with the load (10) with a pulse-width-modulated signal (13), the signal-processing arrangement (14) defining the pulse-width-modulated signal (13) through to a continuous switch-on signal, in the case of which the load (10) is completely switched on, and having a current determination arrangement (17), **characterized in that** the current determination arrangement (17) evaluates the induced voltage (Ui) occurring across an inductive element (18) through which the current (i) flows, and **in that**, in order to change the power, the generation of an interruption signal (U1, U2) is provided, which signal interrupts the continuous switch-on signal at least for a switch-off time (Ta) of the pulse-width-modulated signal (13).

2. Device according to Claim 1, **characterized in that** the interruption signal (U2) is provided by a program which is executed in the signal-processing arrangement (14).

3. Device according to Claim 2, **characterized in that** the generation of the interruption signal (U2) is provided after every program run.

4. Device according to Claim 1, **characterized in that** the interruption signal (U1) is an external signal.

5. Device according to Claim 1, **characterized in that** the interruption signal (U1, U2) interrupts the continuous switch-on signal for the duration of a clock phase (Tp), which corresponds to an integer multiple of the basic period duration (Tg) of the pulse-width-modulated signal (13).

6. Device according to one of the preceding claims, **characterized in that** the evaluation of the induced voltage (Ui) is provided in the region of the switch-off time (Ta) of the pulse-width-modulated signal (13).

7. Device according to Claim 1, **characterized in that** the inductive element (18) is a conductor track arranged on a printed circuit.

## Revendications

1. Dispositif pour agir sur la puissance électrique d'une charge (10) comprenant un dispositif de traitement de signal (14) commandant un interrupteur (12) branché en série avec la charge (10), la commande se faisant avec un signal à largeur d'impulsion modulé (13).
le dispositif de traitement de signal (14) fixant le signal à largeur d'impulsion modulé (13) jusqu'à un signal de durée permanente pour lequel la charge (10) est complètement coupée, et avec un moyen de détermination de l'intensité (17),
**caractérisé en ce que**
le moyen pour déterminer l'intensité (17) du courant reçoit une tension (Ui) induite, produite par un élément inductif (18) traversé par le courant (i), et pour la variation de puissance, il est prévu de générer un signal de coupure (U1, U2) qui coupe le signal de branchement permanent au moins pendant un temps de coupure (Ta) du signal à largeur d'impulsion modulé (13).

2. Dispositif selon la revendication 1,
**caractérisé en ce que**
le signal d'interruption (U1) fournit un programme qui se déroule dans le dispositif de traitement de signal (14).

3. Dispositif selon la revendication 2,
**caractérisé en ce que**
le signal d'interruption (U2) est généré après chaque parcours du programme.

4. Dispositif selon la revendication 1,
**caractérisé en ce que**
le signal d'interruption (U1) est un signal externe.

5. Dispositif selon la revendication 1,
**caractérisé en ce que**
le signal d'interruption (U1, U2) interrompt le signal de branchement permanent pour la durée d'une phase de cadence (Tp) correspondant à un multiple entier de la durée (Tg) de la période de base du signal à largeur d'impulsion modulé (13).

6. Dispositif selon l'une quelconque des revendications précédentes,
**caractérisé en ce que**
l'exploitation de la tension induite (Ui) se fait dans la plage de la durée de coupure (Ta) du signal à largeur d'impulsion modulé (13).

7. Dispositif selon la revendication 1,
**caractérisé en ce que**
l'élément inductif (18) est un chemin conducteur installé sur un circuit imprimé.
